# EUROPÄISCHE PATENTSCHRIFT

(11) **EP 3 005 415 B1**
(45) Veröffentlichungstag und Bekanntmachung des Hinweises auf die Patenterteilung: **19.12.2018**
(21) Anmeldenummer: 14741791.9
(22) Anmeldetag: 05.06.2014
(51) Int. Cl.: H01L 21/687

(54) **HALTEVORRICHTUNG, VERFAHREN ZU DEREN HERSTELLUNG UND VERWENDUNG DERSELBEN**
SUPPPORT, METHOD OF MANUFACTURING A SUPPORT AND USE OF THE SAME
SUPPORT, PROCEDE DE FABRICATION ET UTILISATION D'UN SUPPORT

(30) Priorität: 06.06.2013 DE 102013105882
(43) Veröffentlichungstag der Anmeldung: 13.04.2016
(73) Patentinhaber: Centrotherm Photovoltaics AG, 89143 Blaubeuren (DE)
(72) Erfinder: VÖLK, Hans-Peter, 89608 Griesingen (DE); PIECHULLA, Alexander, 89143 Blaubeuren (DE); WALK, Ulrich, 89079 Gögglingen (DE); FUCHS, Jens-Uwe, 89231 Neu-Ulm (DE); ZERNICKEL, Dieter, 73340 Amstetten (DE)
(74) Vertreter: Heyerhoff Geiger & Partner Patentanwälte PartGmbB
(86) Internationale Anmeldenummer: PCT/DE2014/100190
(87) Internationale Veröffentlichungsnummer: WO 2014/194892

(56) Entgegenhaltungen:
- JP-A- H1 186 181
- JP-A- H11 186 181
- JP-A- 2000 164 522
- JP-A- 2008 034 729
- US-A1- 2002 047 122

## Beschreibung

Die Erfindung betrifft eine Haltevorrichtung, ein Verfahren zur Herstellung der Haltevorrichtung sowie deren Verwendung.

Bei der Herstellung von Halbleiterbauelementen, insbesondere von Siliziumsolarzellen, werden häufig plasmagetriebene Abscheidungen aus der Gasphase durchgeführt, welche im englischen Sprachraum als plasma-enhanced chemical vapor deposition (PECVD) bezeichnet werden. Hierbei sind die zu beschichtenden Halbleitersubstrate üblicherweise in Haltevorrichtungen angeordnet. Bei PECVD-Abscheidungen werden regelmäßig sogenannte Boote als Haltevorrichtungen eingesetzt.

Bei der industriellen Fertigung von Siliziumsolarzellen werden häufig Siliziumsolarzellensubstrate in diesen Booten, welche teilweise auch als PECVD-Boote bezeichnet werden, angeordnet und im Rahmen einer PECVD-Abscheidung mit einer Antireflexionsschicht aus Siliziumnitrid versehen. Homogene Antireflexionsschichten erhält man jedoch nur, wenn das verwendete Boot zuvor bereits mit einer Siliziumnitridschicht versehen wurde. Üblicherweise werden die eingesetzten Boote daher im Rahmen einer sogenannten Siliziumnitrid-Vorbelegung mit Siliziumnitrid beschichtet, ehe eine Beschichtung von in den Booten angeordneten Solarzellensubstraten mit Siliziumnitrid durchgeführt wird. Als Material für die Boote wird üblicherweise Graphitverwendet. Möglicherweise ist das Erfordernis der Siliziumnitrid-Vorbelegung darauf zurückzuführen, dass die elektrischen Oberflächenwiderstände von Graphit und den Siliziumsolarzellensubstraten zu unterschiedlich sind. Es können jedoch auch morphologische oder chemische Gründe, die Porosität des Bootmaterials oder dessen Korngrößenbeschaffenheit eine Rolle spielen. Die Ursachen sind derzeit nicht abschließend geklärt.

Da Siliziumnitrid als Dielektrikum elektrisch isolierend wirkt und für die PECVD-Abscheidung von Siliziumnitrid auf den Siliziumsolarzellensubstraten ein elektrisch leitender Kontakt zwischen dem Boot und den darin angeordneten Siliziumsolarzellensubstraten erforderlich ist, müssen bei der Siliziumnitrid-Vorbelegung diejenigen Bereiche, in welchen die Siliziumsolarzellensubstrate an dem Boot zur Anlage kommen, von der Siliziumnitrid-Vorbelegung ausgespart werden. Dies wird üblicherweise realisiert, indem in diesen Bereichen während der Siliziumnitrid-Vorbelegung Siliziumsubstrate angeordnet werden, welche üblicherweise als Dummy-Wafer bezeichnet werden und in den genannten Bereichen eine Siliziumnitridabscheidung auf Haltenasen oder von den Dummy-Wafern bedeckten Abschnitten der Bootoberfläche weitgehend verhindern. Unter Haltenasen sind dabei Vorsprünge an den Oberflächen der Boote zu verstehen, an welchen die Siliziumsolarzellensubstrate abgestützt werden. Die Haltenasen tragen wesentlich zur elektrischen Kontaktierung bei, da die Siliziumsubstrate während Siliziumnidritabscheidungen häufig nicht mit ausreichender Fläche an dem verwendeten Boot anliegen.

Sind bei einer PECVD-Abscheidung sauerstoffhaltige Gase vorhanden, beispielsweise bei einem Einsatz von Lachgas oder Stickstoffmonoxid als Prozessgas, so kann die Siliziumnitrid-Vorbelegung eine Zersetzung der Boote in denjenigen Bereichen, welche während der Siliziumnitrid-Vorbelegung durch die Dummy-Wafer abgeschirmt waren, nicht verhindern. Dies gilt in gleicher Weise für andere Haltevorrichtungen, wie beispielsweise in Schnellbearbeitungsanlagen, sogenannten Rapid Thermal Processing (RTP)-Anlagen verwendete Suszeptoren. Die beschriebene Zersetzung in sauerstoffhaltigen Prozessgasatmosphären führt zum Verschleiß der eingesetzten Haltevorrichtung. Es wird noch Bezug genommen auf die Dokumente JP2008034729, US2002047122, JPH11186181 und JP2000164522.

Der vorliegenden Erfindung gemäss dem unabhängigen Vorrichtungsanspruch 1 liegt daher die Aufgabe zugrunde, eine Haltevorrichtung zur Verfügung zu stellen, welche in sauerstoffhaltigen Prozessgasatmosphären eine verbesserte Verschleißbeständigkeit aufweist.

Weiterhin liegt der Erfindung die Aufgabe zugrunde, eine aufwandsgünstige Beschichtung von Substraten zu ermöglichen. Diese Aufgabe wird gelöst durch eine Verwendung der erfindungsgemäßen Haltevorrichtung gemäß Anspruch 6. Ferner liegt der Erfindung die Aufgabe zugrunde, ein aufwandsgünstiges Verfahren zur Herstellung der erfindungsgemäßen Haltevorrichtung zur Verfügung zu stellen.
Diese Aufgabe wird gelöst durch ein Verfahren mit den Merkmalen des Anspruchs 9.
Vorteilhafte Weiterbildungen sind jeweils Gegenstand abhängiger Unteransprüche.
Die erfindungsgemäße Haltevorrichtung weist an ihrer Oberfläche eine Beschichtung aus Siliziumkarbid, Glaskohlenstoff oder pyrolytischem Kohlenstoff auf.
Mit derart beschichteten Haltevorrichtungen kann eine erhöhte Verschleißbeständigkeit in sauerstoffhaltigen Prozessgasatmosphären realisiert werden. Dies ist insbesondere bei sauerstoffhaltigen Prozessgasatmosphären der Fall, welche unter Verwendung von Lachgas und/oder Stickstoffmonoxid als Prozessgasen gebildet werden.

Die genannten Beschichtungsmaterialien können grundsätzlich auf jede an sich bekannte Weise aufgebracht werden. Eine Beschichtung aus Glaskohlenstoff kann beispielsweise aufgebracht werden, indem einem Alkoholbad Phenolharzpulver beigemischt und der zu beschichtende Gegenstand in die resultierende Lösung eingetaucht wird. Nachfolgend wird der zu beschichtende Gegenstand auf eine Temperatur von mindestens 600°C erwärmt. Diese Vorgehensweise hat sich insbesondere bei zu beschichtenden Gegenständen aus Graphit bewährt.

Vorzugsweise wird eine Beschichtung aus Siliziumkarbid vorgesehen. Siliziumkarbid ist abriebfest und gegenüber Flusssäure beständig. In den meisten Anwendungsfällen bedarf es somit nur sehr selten einer Nachbeschichtung mit Siliziumkarbid. Des Weiteren haftet Siliziumkarbid gut auf Graphit, welches ein gängiges Material für in der Halbleitertechnik eingesetzte Haltevorrichtungen ist. Ferner hat sich gezeigt, dass Graphitkörper mit einer Siliziumkarbidbeschichtung einen ähnlichen elektrischen Oberflächenwiderstand aufweisen wie Siliziumsolarzellensubstrate. Dies scheint sich vorteilhaft auf die Eigenschaften von mittels PECVD-Verfahren auf Siliziumsolarzellensubstraten abgeschiedene Schichten auszuwirken. Jedoch können auch morphologische oder chemische Gründe oder die Porosität oder die Korngrößenbeschaffenheit des Graphits hierbei eine Rolle spielen. Jedenfalls hat sich gezeigt, dass die eingangs beschriebene Siliziumnitrid-Vorbelegung bei siliziumkarbidbeschichteten Haltevorrichtungen, insbesondere bei siliziumkarbidbeschichteten Booten, entfallen kann, ohne dass die Homogenität einer unter Verwendung solch einer Haltevorrichtung abgeschiedenen Siliziumnitridschicht, beispielsweise einer Antireflexionsbeschichtung, hierdurch in relevantem Umfang beeinträchtigt wird. Da Siliziumkarbid elektrisch leitfähig ist, werden zudem die oben beschriebenen Dummy-Wafer nicht benötigt. Bei der industriellen Fertigung von Siliziumsolarzellen ist der Bedarf an Dummy-Wafern ein nicht vernachlässigbarer Kostenfaktor, sodass der Einsatz der erfindungsgemäßen Haltevorrichtung und der damit entfallende Bedarf an Dummy-Wafern eine Reduktion des Fertigungsaufwandes ermöglicht.

Unter Siliziumkarbid beziehungsweise einer Siliziumkarbidbeschichtung ist vorliegend zu verstehen, dass das eingesetzte Material beziehungsweise die betroffene Beschichtung im Wesentlichen aus Siliziumkarbid besteht. Eine vollkommene Reinheit des Werkstoffes ist nicht erforderlich. Verunreinigungen, Fremdmaterialeinträge an Grenzflächen oder anderes können in praktisch üblichen Mengen vorhanden sein.

Werden erfindungsgemäße Haltevorrichtungen bei Siliziumnitridabscheidungen eingesetzt, so wird auch auf der verwendeten Haltevorrichtung Siliziumnitrid abgeschieden. Nach einer gewissen Anzahl von Abscheidungen kommt es zu Abplatzungen von Siliziumnitridteilen von der Haltevorrichtung. Hierdurch kann die Qualität der Siliziumnitridschicht beeinträchtigt werden, welche auf einem in der Haltevorrichtung angeordneten Objekt abgeschieden wird. Aus diesem Grund werden Haltevorrichtungen von Siliziumnitridabscheideanlagen üblicherweise nach einer gewissen Zahl von Abscheidungen zurückgeätzt. Es hat sich gezeigt, dass bei der Verwendung einer erfindungsgemäßen Haltevorrichtung die Zahl der möglichen Abscheidungen, bevor ein nächster Rückätzschritt erforderlich ist, gegenüber bislang bekannten Haltevorrichtungen erhöht werden kann. Dies ist insbesondere bei Haltevorrichtungen der Fall, welche eine Beschichtung aus Siliziumkarbid aufweisen. Die höhere Zahl der mit einer Haltevorrichtung bis zum nächsten Rückätzvorgang durchführbaren Siliziumnitridabscheidungen ermöglicht in der industriellen Anwendung, beispielsweise bei der industriellen Solarzellenfertigung, eine weitere Reduktion des Fertigungsaufwandes.

Ist die Haltevorrichtung mit einer Beschichtung aus pyrolytischem Kohlenstoff versehen, so ergibt sich gegenüber einer Beschichtung mit Glaskohlenstoff bei hohen Temperaturen von bis zu 1100°C eine verbesserte Resistenz gegenüber Sauerstoff und Sauerstoffradikalen. Eine pyrolytisch abgeschiedene Kohlenstoffschicht kann durch eine Infiltration mit pyrolytisch abgeschiedenem Kohlenstoff kombiniert werden. Eine derartige Kombination haftet sehr gut auf Graphit und ist sehr dicht. Ferner weist sie gegenüber einer einfachen pyrolytisch abgeschiedenen Kohlenstoffschicht eine deutlich härtere Oberfläche auf und ist resistenter gegenüber Sauerstoff und Sauerstoffradikalen. Derartige Haltevorrichtungen sind dementsprechend verschleißfester gegenüber mechanischen Beanspruchungen und widerstandsfähiger gegenüber einer Zersetzung in sauerstoffhaltigen Prozessumgebungen.

Eine Weiterbildung sieht vor, dass die Haltevorrichtung überwiegend aus Graphit oder Glas besteht. Vorzugsweise besteht sie, abgesehen von der Beschichtung, vollständig aus Graphit oder Glas. Bei dem genannten Glas kann es sich insbesondere um ein Quarzglas handeln. In der Praxis hat sich, insbesondere bei der Herstellung von Halbleiterbauelementen, Graphit besonders bewährt, weswegen dieses Material besonders bevorzugt wird.

Die Beschichtung ist vorteilhaftweise unmittelbar auf einem Kernmaterial der Haltevorrichtung angeordnet. Vor- oder Zwischenbeschichtungen können auf diese Weise entfallen.

Vorteilhafterweise erstreckt sich die Beschichtung über die gesamte Oberfläche der Haltevorrichtung, sodass die erhöhte Verschleißbeständigkeit über die gesamte Oberfläche der Haltevorrichtung hinweg vorliegt. Ist die Haltevorrichtung als Graphitboot ausgeführt, so erstreckt sich die Beschichtung vorzugsweise über sämtliche elektrisch leitfähigen Oberflächenanteile des Graphitboots.

In einer besonders bevorzugten Ausgestaltungsvariante ist als Beschichtung eine Siliziumkarbidbeschichtung vorgesehen mit einer Dicke von weniger als 25 µm. Vorzugsweise ist die Dicke geringer als 10 µm und besonders bevorzugt weist die Dicke einen Maximalwert von 10 µm und einem Minimalwert von 1 µm auf. Im letztgenannten Fall variiert die Dicke der Siliziumkarbidbeschichtung somit in einem Intervall mit einer unteren Intervallgrenze von 1 µm und einer oberen Intervallgrenze von 10 µm. Es hat sich gezeigt, dass bei derart ausgestalteten Siliziumkarbidbeschichtungen die Verschleißbeständigkeit der Haltevorrichtung besonders effizient erhöht werden kann.

In einer Ausgestaltungsvariante ist die Haltevorrichtung als Boot für Dampfabscheideanlagen ausgeführt. Bei den Dampfabscheideanlagen kann es sich um physikalische (physical vapour deposition - PVD) oder chemische Dampfabscheideanlagen (chemical vapour deposition - CVD) handeln. Vorzugsweise ist das Boot dazu geeignet, Siliziumsubstrate aufzunehmen. Besonders bevorzugt wird das Boot derart ausgelegt, dass es zur Verwendung in PECVD-Anlagen geeignet ist.

In einer anderen Ausführungsvariante ist die Haltevorrichtung als Suszeptor für RTP-Öfen ausgeführt. Unter RTP-Öfen sind dabei Öfen zu verstehen, welche zur schnellen thermischen Bearbeitung (rapid thermal processing) von Gegenständen, insbesondere von Halbleitersubstraten, geeignet sind. PRT-Öfen werden häufig mittels Halogenlampen beheizt und ermöglichen ein sehr schnelles Erwärmen des Gegenstandes.

Die erfindungsgemäße Verwendung sieht vor, dass eine als Boot für Dampfabscheideanlagen ausgeführte Haltevorrichtung bei einer plasmagetriebenen Abscheidung aus der Gasphase als Haltevorrichtung für Substrate verwendet wird. Auf diese Weise können die Substrate aufwandsgünstig beschichtet werden, da die Haltevorrichtung eine erhöhte Verschleißbeständigkeit in sauerstoffhaltiger Prozessgasatmosphäre aufweist.

Vorzugsweise wird die Haltevorrichtung für Siliziumsubstrate und besonders bevorzugt für Siliziumsolarzellensubstrate verwendet. Auf diese Weise kann, insbesondere bei der Verwendung von Booten, bei welchen die Beschichtung aus Siliziumkarbid gebildet ist, im Falle einer Siliziumnitridabscheidung auf eine Siliziumnitrid-Vorbelegung verzichtet und von einem Einsatz von Dummy-Wafern abgesehen werden. Diese Sachverhalte wurden oben bereits im Zusammenhang mit der Haltevorrichtung näher erläutert. Im Ergebnis können somit Siliziumsubstrate, beziehungsweise Siliziumsolarzellensubstrate, aufwandsgünstiger beschichtet werden.

Vorteilhafterweise wird daher bei der plasmagetriebenen Abscheidung aus der Gasphase Siliziumnitrid oder Siliziumoxinitrid auf den Substraten abgeschieden, vorzugsweise Siliziumnitrid. Insbesondere bei einer Abscheidung auf Siliziumsubstraten, beziehungsweise Siliziumsolarzellensubstraten, kann auf diese Weise eine deutliche Reduktion des Fertigungsaufwands bewirkt werden.

Aufgrund der erhöhten Verschleißbeständigkeit der Haltevorrichtung in einer sauerstoffhaltigen Prozessgasatmosphäre kann das Boot besonders vorteilhaft verwendet werden bei denjenigen PECVD-Abscheidungen, bei welchen zumindest zeitweise eine sauerstoffhaltige Prozessgasatmosphäre ausgebildet wird. Insbesondere im Fall einer Verwendung von Graphitbooten ist dies von Vorteil, da auf diese Weise deren Verschleiß verringert werden kann. Bei PECVD-Siliziumoxidabscheidungen hat sich die Verwendung des Bootes daher als vorteilhaft erwiesen.

Die Vorteile, welche die erfindungsgemäße Verwendung bietet, stellen sich nach jetzigem Kenntnisstand unabhängig davon ein, ob die Beschichtung in etwa bei Atmosphärendruck oder geringeren Druckwerten erfolgt, unabhängig davon ob es sich um eine ionische oder radikale Beschichtungsart handelt und auch unabhängig von der verwendeten Plasmafrequenz. Besonders bewährt hat sich die erfindungsgemäße Verwendung in Verbindung mit Plasmafrequenzen kleiner als 400 kHz und ganz besonders in Verbindung mit einer Plasmafrequenz von 40 kHz sowie in Verbindung mit einer Plasmafrequenz von 13,56 kHz oder 2,45 GHz.

Das Verfahren zur Herstellung einer erfindungsgemäßen Haltevorrichtung sieht vor, mittels einer chemischen Abscheidung aus der Gasphase Siliziumkarbid als Beschichtung auf einem Volumenmaterial der Haltevorrichtung abzuscheiden.

Unter dem Begriff des Volumenmaterials ist vorliegend das Material zu verstehen, aus dem die Haltevorrichtung vor Aufbringung der Beschichtung besteht. Sofern die Haltevorrichtung vor dem Aufbringen der Beschichtung nicht aus einem einheitlichen Material besteht, umfasst der Begriff des Volumenmaterials somit sämtliche Materialien, aus denen die Haltevorrichtung zu diesem Zeitpunkt besteht, mit Ausnahme von Fügeteilen wie beispielsweise Distanzelementen oder Verbindungselementen. Insbesondere sind etwaige zuvor bereits aufgebrachte Zusatzbeschichtungen eingeschlossen.

Mit dem beschriebenen Verfahren kann die Haltevorrichtung aufwandsgünstig mit der Beschichtung versehen werden. Dies ist insbesondere dann der Fall, wenn die Haltevorrichtung zur Verwendung in einer CVD-Anlage vorgesehen ist. Denn in diesem Fall kann diese CVD-Anlage, die beispielsweise als PECVD-Anlage ausgeführt sein kann, sowohl zur Beschichtung der Haltevorrichtung verwendet werden wie auch zur Beschichtung von später in der Haltevorrichtung angeordneten Gegenständen. Bei diesen Gegenständen kann es sich zum Beispiel um Substrate handeln. Eine derartige Beschichtung der Haltevorrichtung mit Siliziumkarbid ist wesentlich aufwandsgünstiger als eine externe CVD-Abscheidung. Bereits vorhandene CVD-, beziehungsweise PECVD-, Anlagen müssen in der Regel nur geringfügig modifiziert werden um die Siliziumkarbidabscheidung zu ermöglichen. Im Falle einer bereits für eine Siliziumnitridabscheidung angerichteten PECVD-Anlage ist beispielsweise lediglich eine Zuführvorrichtung für Methan zusätzlich vorzusehen.

Vorteilhafterweise wird die Beschichtung auf einem Volumenmaterial abgeschieden, welches überwiegend, vorzugsweise vollständig, aus Graphit oder Glas besteht. Diese Materialien haben sich in der Praxis bewährt und können in vielen Anwendungsfällen als Haltevorrichtungen eingesetzt werden, insbesondere in Anwendungsfällen der Halbleiterbauelementfertigung. Besonders bevorzugt wird ein überwiegend oder vollständig aus Graphit bestehendes Volumenmaterial beschichtet, da dieses Material für den Einsatz in PECVD-Anlagen aufgrund seiner elektrischen Leitfähigkeit im Regelfall besser geeignet ist.

Die Abscheidung des Siliziumkarbids erfolgt bevorzugt mittels einer plasmagetriebenen Abscheidung aus der Gasphase oder in anderen Worten mittels einer PECVD-Abscheidung. Für die Abscheidung wird vorteilhafterweise ein direktes Plasma an einer Oberfläche der Haltevorrichtung ausgebildet. Dies hat sich insbesondere als dann als vorteilhaft erwiesen, wenn das direkte Plasma an einer Graphitoberfläche ausgebildet wird.

Für die Abscheidung des Siliziumkarbids kann ein unter Verwendung von Methan und Silan gebildetes Plasma verwendet werden. Vorzugsweise kommt ein Plasma zum Einsatz, welches aus Methan und Silan gebildet wird.

In einer vorteilhaften Ausführungsvariante wird das abgeschiedene Siliziumkarbid verdichtet. Dies kann beispielsweise mittels eines Ionenbombardements bewirkt werden und wird besonders bevorzugt mittels eines Plasmas realisiert. Besonders bewährt hat sich in diesem Zusammenhang ein Niederfrequenzplasma mit einer Plasmafrequenz kleiner als 400 kHz.

Im Weiteren wird die Erfindung anhand von Figuren näher erläutert. Soweit zweckdienlich, sind hierin gleichwirkende Elemente mit gleichen Bezugszeichen versehen. Die Erfindung ist nicht auf die in den Figuren dargestellten Ausführungsbeispiele beschränkt - auch nicht in Bezug auf funktionale Merkmale. Die bisherige Beschreibung wie auch die nachfolgende Figurenbeschreibung enthalten zahlreiche Merkmale, die in den abhängigen Unteransprüchen teilweise zu mehreren zusammengefasst wiedergegeben sind. Diese Merkmale wie auch alle übrigen oben und in der nachfolgenden Figurenbeschreibung offenbarte Merkmale wird der Fachmann jedoch auch Einzeln betrachten und zu sinnvollen weiteren Kombinationen zusammenfügen. Insbesondere sind diese Merkmale jeweils einzeln und in beliebiger geeigneter Kombination mit der Haltevorrichtung und/oder dem Verfahren und/oder der Verwendung gemäß den unabhängigen Ansprüchen kombinierbar. Es zeigen:
- Figur 1: Ein Ausführungsbeispiel einer als Boot für Dampfabscheideanlagen ausgeführten Haltevorrichtung in schematischer Darstellung
- Figur 2: Ein Ausführungsbeispiel einer als Suszeptor für RTP-Öfen ausgeführten Haltevorrichtung in schematischer Darstellung
- Figur 3: Schematische Teilschnittdarstellung durch die Haltevorrichtung gemäß Figur 2 beziehungsweise durch die Haltevorrichtung aus Figur 1
- Figur 4: Ein Ausführungsbeispiel des erfindungsgemäßen Verfahrens
- Figur 5: Ein Ausführungsbeispiel der erfindungsgemäßen Verwendung

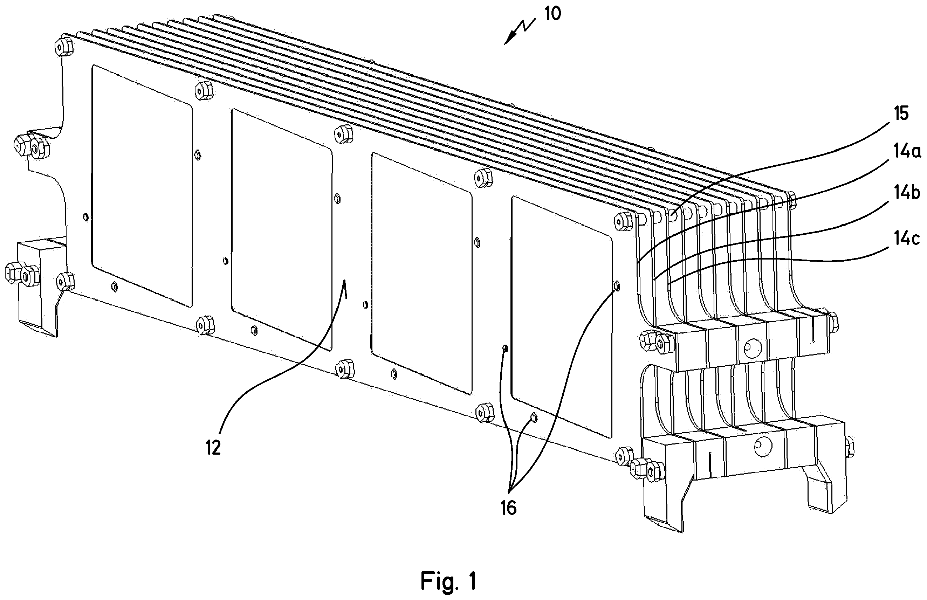

Figur 1 illustriert in einer schematischen Perspektivdarstellung ein Ausführungsbeispiel einer als Boot 10 für Dampfabscheideanlagen, vorliegend für eine PECVD-Anlage, ausgeführten Haltevorrichtung. Das Boot 10 ist dazu geeignet, Siliziumsubstrate und insbesondere Siliziumsolarzellensubstrate aufzunehmen und ist in an sich bekannter Weise aus mehreren Platten 14a, 14b, 14c sowie weiteren Platten zusammengesetzt. Zur Aufnahme von Siliziumsubstraten sind für jedes der Siliziumsubstrate drei Haltenasen 16 vorgesehen.

Das Volumenmaterial des Bootes 10 besteht im Ausführungsbeispiel der Figur 1, abgesehen von Isolatoren 15, aus Graphit, auf welchem unmittelbar eine Beschichtung 12 aus Siliziumkarbid angeordnet ist. Anstelle von Siliziumkarbid könnte auch Glaskohlenstoff oder pyrolytischer Kohlenstoff vorgesehen sein.

Die Beschichtung 12 erstreckt sich, abgesehen von den als Abstandshaltern und somit als Distanzelemente verwendeten Isolatoren 15, über die gesamte Oberfläche des Bootes 10 und weist eine Dicke zwischen 1 µm und 10 µm auf.

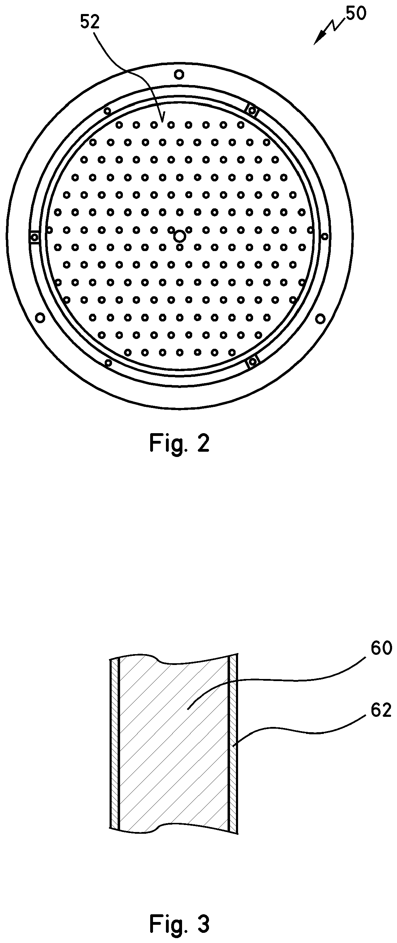

Figur 2 zeigt in einer schematischen Aufsichtdarstellung ein Ausführungsbeispiel einer als Suszeptor 50 für RTP-Öfen ausgeführten Haltevorrichtung in schematischer Darstellung. Der Suszeptor 50 weist an seiner Oberfläche eine Beschichtung 12 aus Siliziumkarbid auf, welche sich über die gesamte Oberfläche des Suszeptors 52 erstreckt und eine Dicke zwischen 1 µm und 10 µm aufweist. Abgesehen von der Beschichtung 52 besteht der Suszeptor vollständig aus Graphit oder Glas. Anstelle der Beschichtung 52 aus Siliziumkarbid kann die Beschichtung auch aus Glaskohlenstoff oder pyrolytischem Kohlenstoff gebildet sein.

Die Beschichtung 52 ist unmittelbar auf einem Volumenmaterial des Suszeptors 50 angeordnet, welches in der erwähnten Weise aus Graphit oder Glas besteht. Dies wird nachfolgend näher anhand der Darstellung in Figur 3 erläutert.

Figur 3 zeigt eine schematische Teilschnittdarstellung durch den Suszeptor 50 aus Figur 2, beziehungsweise durch das Boot 10 aus Figur 1. Im Falle des Boots 10 aus Figur 1 könnte Figur 3 beispielsweise einen Teilschnitt durch die Platte 14a darstellen. Figur 3 zeigt ein Volumenmaterial 60, welches an allen Oberflächen mit einer Beschichtung 62 versehen ist. Wird Figur 3 als Teilschnittdarstellung durch das Boot 10 aus Figur 1 aufgefasst, so stellt die Beschichtung 62 die Siliziumkarbidbeschichtung 52 aus Figur 1 dar und bei dem Volumenmaterial 60 handelt es sich um Graphit. Wird Figur 3 andererseits als Teilschnittdarstellung durch Figur 2 aufgefasst, so stellt die Beschichtung 62 die Beschichtung 52 aus Siliziumkarbid dar und das Volumenmaterial 60 ist Graphit oder Glas. In den Ausführungsbeispielen der Figuren 1 bis 3 stellt das Volumenmaterial 60 jeweils auch das Kernmaterial des Bootes 10 beziehungsweise des Suszeptors 50 dar. Vor- oder Zwischenbeschichtungen sind nicht vorhanden.

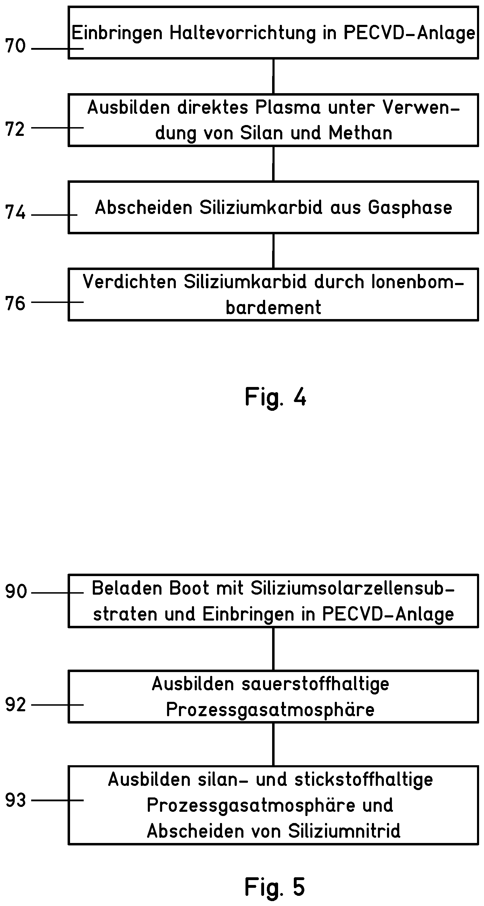

Figur 4 zeigt eine Prinzipdarstellung eines Ausführungsbeispiels des erfindungsgemäßen Verfahrens. Bei diesem wird zunächst eine Haltevorrichtung, beispielsweise ein Boot oder ein Suszeptor, in eine PECVD-Anlage eingebracht 70. Im Weiteren wird in der PECVD-Anlage unter Verwendung von Silan und Methan ein direktes Plasma an einer Oberfläche der Haltevorrichtung ausgebildet 72. Es erfolgt eine Abscheidung 74 von Siliziumkarbid mittels einer plasmagetriebenen Abscheidung aus der Gasphase. Darüber hinaus wird das abgeschiedene Siliziumkarbid durch Ionenbombardement verdichtet 76. Die hierfür eingesetzten Ionen werden vorzugsweise mittels eines Niederfrequenzplasmas Plasma erzeugt.

Figur 5 illustriert in einer Prinzipdarstellung ein Ausführungsbeispiel der erfindungsgemäßen Verwendung. Hierbei wird eine als Boot für Dampfabscheideanlagen ausgeführte Haltevorrichtung mit Siliziumsolarzellensubstraten beladen und in eine PECVD-Anlage eingebracht 90. In dieser PECVD-Anlage wird eine sauerstoffhaltige Prozessgasatmosphäre ausgebildet 92, in welcher im vorliegenden Ausführungsbeispiel eine Siliziumoxinitridschicht auf den Siliziumsolarzellensubstraten ausgebildet wird. Im Weiteren wird eine silan- und stickstoffhaltige Prozessgasatmosphäre ausgebildet und hierin Siliziumnitrid in Gestalt einer siliziumnitridhaltigen Schicht auf den Siliziumsolarzellensubstraten abgeschieden 93. In dem dargestellten Ausführungsbeispiel der Figur 5 wird als Boot das in Figur 1 dargestellte, mit einer Beschichtung 12 aus Siliziumkarbid versehene und ein Volumenmaterial aus Graphit aufweisende Boot 10 verwendet, sodass das Boot 10 gegenüber einem vorzeitigen Verschleiß in der sauerstoffhaltigen Prozessgasatmosphäre durch die Beschichtung 12 aus Siliziumkarbid geschützt ist. Wie oben dargelegt wurde, kann bei dieser Ausführungsvariante auf eine Siliziumnitrid-Vorbelegung des Bootes 10 ebenso verzichtet werden wie auf den materialaufwändigen Einsatz von Dummy-Wafern. Das Ausführungsbeispiel der Figur 5 ermöglicht somit eine aufwandsgünstige Beschichtung der Siliziumsolarzellensubstrate mit Siliziumnitrid, beispielsweise als Antireflexionsbeschichtung.

### Bezugszeichenliste

- 10: Boot
- 12: Beschichtung
- 14a: Platte
- 14b: Platte
- 14c: Platte
- 15: Isolator
- 16: Haltenasen
- 50: Suszeptor
- 52: Beschichtung
- 60: Volumenmaterial
- 62: Beschichtung
- 70: Einbringen Haltevorrichtung in PECVD-Anlage
- 72: Ausbilden Plasma unter Verwendung von Silan und Methan
- 74: Abscheiden Siliziumkarbid aus Gasphase
- 76: Verdichten Siliziumkarbid durch Ionenbombardement mittels des Plasmas
- 90: Beladen Boot mit Siliziumsolarzellensubstraten und Einbringen in PECVD-Anlage
- 92: Ausbilden sauerstoffhaltige Prozessgasatmosphäre und Abscheiden von Siliziumnitrid
- 93: Ausbilden silan- und stickstoffhaltige Prozessgasatmosphäre und Abscheiden von Siliziumnitrid

## Patentansprüche

1. Haltevorrichtung (10; 50) für Halbleitersubstrate wobei
- die Haltevorrichtung (10; 50) an ihrer Oberfläche eine Beschichtung (12; 52) aus Siliziumkarbid aufweist; und
- die Beschichtung (62) unmittelbar auf einem Kernmaterial (60) der Haltevorrichtung (10; 50) angeordnet ist;
**dadurch gekennzeichnet,**
**dass** eine Dicke der Siliziumkarbidbeschichtung einen Maximalwert von 10 µm und einen Minimalwert von 1 µm aufweist.

2. Haltevorrichtung (10; 50) nach Anspruch 1,
**dadurch gekennzeichnet,**
**dass** die Haltevorrichtung (10; 50) überwiegend, vorzugsweise bis auf die Beschichtung (12; 52) vollständig, aus Graphit oder Glas besteht.

3. Haltevorrichtung (10; 50) nach einem der vorangegangenen Ansprüche,
**dadurch gekennzeichnet,**
**dass** die Beschichtung sich über die gesamte Oberfläche der Haltevorrichtung (50) erstreckt.

4. Haltevorrichtung (10) nach einem der vorangegangenen Ansprüche,
**dadurch gekennzeichnet,**
**dass** die Haltevorrichtung (10) als Boot (10) für Dampfabscheideanlagen ausgeführt ist, welches vorzugsweise dazu geeignet ist, Siliziumsubstrate aufzunehmen.

5. Haltevorrichtung (50) nach einem der Ansprüche 1 bis 3,
**dadurch gekennzeichnet,**
**dass** die Haltevorrichtung (50) als Suszeptor (50) für RTP-Öfen ausgeführt ist.

6. Verwendung (90, 92) eines Bootes (10) nach Anspruch 4 bei einer plasmagetriebenen Abscheidung aus der Gasphase als Haltevorrichtung (10) für Substrate, vorzugsweise für Siliziumsubstrate und besonders bevorzugt für Siliziumsolarzellensubstrate.

7. Verwendung (90, 92) nach Anspruch 6,
**dadurch gekennzeichnet,**
**dass** bei der plasmagetriebenen Abscheidung aus der Gasphase Silziumoxid, Siliziumoxinitrid oder Siliziumnitrid auf den Substraten abgeschieden wird (92), vorzugsweise Siliziumnitrid.

8. Verwendung (90, 92) nach einem der Ansprüche 6 bis 7,
**dadurch gekennzeichnet,**
**dass** bei der plasmagetriebenen Abscheidung aus der Gasphase zumindest zweitweise eine sauerstoffhaltige Prozessgasatmosphäre ausgebildet wird (92).

9. Verfahren zur Herstellung einer Haltevorrichtung (10; 52) gemäß einem der Ansprüche 1 bis 5,
bei welchem mittels einer chemischen Abscheidung aus der Gasphase (14) Siliziumkarbid als Beschichtung (12; 52, 62) auf einem Volumenmaterial (60) der Haltevorrichtung (10;
50) abgeschieden wird (14);
**dadurch gekennzeichnet,**
**dass** das abgeschiedene Siliziumkarbid verdichtet wird (76).

10. Verfahren nach Anspruch 9,
**dadurch gekennzeichnet,**
**dass** die Beschichtung (12; 52; 62) auf einem Volumenmaterial (60) abgeschieden wird (14), welches überwiegend, vorzugsweise vollständig, aus Graphit oder Glas besteht.

11. Verfahren nach einem der Ansprüche 9 bis 10,
**dadurch gekennzeichnet,**
**dass** die Abscheidung (14) mittels einer plasmagetriebenen Abscheidung aus der Gasphase erfolgt.

12. Verfahren nach Anspruch 11,
**dadurch gekennzeichnet,**
**dass** das für die Abscheidung (14) verwendete Plasma in Gestalt eines direkten Plasmas an einer Oberfläche der zu beschichtenden Haltevorrichtung (10; 52) ausgebildet wird.

13. Verfahren nach einem der Ansprüche 11 bis 12,
**dadurch gekennzeichnet,**
**dass** für die Abscheidung (14) ein unter Verwendung von Methan und Silan gebildetes (12) Plasma verwendet wird.

14. Verfahren nach einem der Ansprüche 9 bis 13,
**dadurch gekennzeichnet,**
**dass** das abgeschiedene Siliziumkarbid durch Ionenbombardement verdichtet wird (76), vorzugsweise mittels eines Plasmas.

## Claims

1. Retainer (10; 50), for semiconductor substrates, wherein
- the retainer (10; 50) has a coating (12; 52) composed of silicon carbide, on its surface
- the coating (62) is arranged directly on a core material (60) of the retainer (10; 50);
**characterized**
**in that** a thickness of the silicon carbide coating has a maximum value of 10 µm and a minimum value of 1 µm.

2. Retainer (10; 50) according to Claim 1,
**characterized**
**in that** the retainer (10; 50) consists of graphite or glass predominantly, preferably completely apart from the coating (12; 52) .

3. Retainer (10; 50) according to any of the preceding claims,
**characterized**
**in that** the coating extends over the entire surface of the retainer (50).

4. Retainer (10) according to any of the preceding claims,
**characterized**
**in that** the retainer (10) is embodied as a boat (10) for vapor deposition installations, said boat preferably being suitable for receiving silicon substrates.

5. Retainer (50) according to any of Claims 1 to 3,
**characterized**
**in that** the retainer (50) is embodied as a susceptor (50) for RTP furnaces.

6. Use (90, 92) of a boat (10) according to Claim 4 in a plasma-driven vapor deposition as a retainer (10) for substrates, preferably for silicon substrates and particularly preferably for silicon solar cell substrates.

7. Use (90, 92) according to Claim 6,
**characterized**
**in that** in the plasma-driven vapor deposition silicon oxide, silicon oxynitride or silicon nitride is deposited (92) on the substrates, preferably silicon nitride.

8. Use (90, 92) according to either of Claims 6 and 7,
**characterized**
**in that** in the plasma-driven vapor deposition an oxygen-containing process gas atmosphere is formed (92) at least temporarily.

9. Method for producing a retainer (10; 52) according to any of Claims 1 to 5,
in which, by means of a chemical vapor deposition (14), silicon carbide is deposited (14) as a coating (12; 52, 62) on a volume material (60) of the retainer (10; 50); **characterized**
**in that** the deposited silicon carbide is densified (76).

10. Method according to Claim 9,
**characterized**
**in that** the coating (12; 52; 62) is deposited (14) on a volume material (60) which predominantly, preferably completely, consists of graphite or glass.

11. Method according to either of Claims 9 and 10,
**characterized**
**in that** the deposition (14) is effected by means of a plasma-driven vapor deposition.

12. Method according to Claim 11,
**characterized**
**in that** the plasma used for the deposition (14) is embodied in the form of a direct plasma on a surface of the retainer (10; 52) to be coated.

13. Method according to either of Claims 11 and 12,
**characterized**
**in that** a plasma formed (12) using methane and silane is used for the deposition (14).

14. Method according to any of Claims 9 to 13,
**characterized**
**in that** the deposited silicon carbide is densified (76), by ion bombardment, preferably by means of a plasma.

## Revendications

1. Dispositif de maintien (10 ; 50) destiné à des substrats semi-conducteurs, dans lequel
- le dispositif de maintien (10 ; 50) est doté sur sa surface d'un revêtement (12 ; 52) de carbure de silicium ; et
- le revêtement (62) est disposé directement sur un matériau de noyau (60) du dispositif de maintien (10 ; 50) ;
**caractérisé en ce qu'**une épaisseur du revêtement de carbure de silicium présente une valeur maximale de 10 µm et une valeur minimale de 1 µm.

2. Dispositif de maintien (10 ; 50) selon la revendication 1, **caractérisé en ce que** le dispositif de maintien (10 ; 50) est principalement, et de préférence entièrement constitué de graphite ou de verre jusqu'au revêtement (12 ; 52).

3. Dispositif de maintien (10 ; 50) selon l'une des revendications précédentes, **caractérisé en ce que** le revêtement s'étend sur toute la surface du dispositif de maintien (50).

4. Dispositif de maintien (10) selon l'une des revendications précédentes, **caractérisé en ce que** le dispositif de maintien (10) est réalisé sous la forme d'un bateau (10) destiné à des installations de dépôt en phase vapeur, qui est de préférence approprié pour recevoir des substrats de silicium.

5. Dispositif de maintien (50) selon l'une des revendications 1 à 3, **caractérisé en ce que** le dispositif de maintien (50) est réalisé sous la forme d'un suscepteur (50) pour fours RTP.

6. Utilisation (90, 92) d'un bateau (10) selon la revendication 4 lors d'un dépôt activé par plasma en phase gazeuse en tant que dispositif de maintien (10) destiné à des substrats, de préférence en silicium et de manière plus particulièrement préférable, des substrats de cellules solaires en silicium.

7. Utilisation (90, 92) selon la revendication 6, **caractérisée en ce que**, lors du dépôt activé par plasma en phase gazeuse, de l'oxyde de silicium, de l'oxynitrure de silicium ou du nitrure de silicium est déposé (92), de préférence du nitrure de silicium, sur les substrats.

8. Utilisation (90, 92) selon l'une des revendications 6 à 7, **caractérisée en ce qu'**une atmosphère de gaz de traitement contenant de l'oxygène est formée (92) au moins deux fois lors du dépôt activé par plasma en phase gazeuse.

9. Procédé de fabrication d'un dispositif de maintien (10 ; 52) selon l'une des revendications 1 à 5, dans lequel du carbure de silicium est déposé (14) en tant que revêtement (12 ; 52, 62) sur un matériau volumique (60) du dispositif de maintien (10 ; 50) au moyen d'un dépôt chimique en phase gazeuse (14), **caractérisé en ce que** le carbure de silicium déposé est densifié (76).

10. Procédé selon la revendication 9, **caractérisé en ce que** le revêtement (12 ; 52 ; 62) est déposé (14) sur un matériau volumique (60) qui est principalement, et de préférence entièrement constitué de graphite ou de verre.

11. Procédé selon l'une des revendications 9 à 10, **caractérisé en ce que** le dépôt (14) s'effectue au moyen d'un dépôt activé par plasma en phase gazeuse.

12. Procédé selon la revendication 11, **caractérisé en ce que** le plasma utilisé pour le dépôt (14) est réalisé sous la forme d'un plasma direct sur une surface du dispositif de maintien (10 ; 52) devant être revêtu.

13. Procédé selon l'une des revendications 11 à 12, **caractérisé en ce qu'**un plasma (12) formé à partir de méthane et de silane est utilisé pour le dépôt (14).

14. Procédé selon l'une des revendications 9 à 13, **caractérisé en ce que** le carbure de silicium déposé est densifié (76) par bombardement ionique, de préférence au moyen d'un plasma.
